# FASCICULE DE BREVET EUROPEEN

(11) **EP 4 181 201 B1**
(45) Date de publication et mention de la délivrance du brevet: **05.08.2026**
(21) Numéro de dépôt: 22205713.5
(22) Date de dépôt: 07.11.2022
(51) Int. Cl.: G06F 3/043, G09F 9/33, H10H 29/30, G06F 3/01, B06B 1/06, H10K 59/00

(54) **DISPOSITIF D'AFFICHAGE INTERACTIF ET PROCÉDÉ DE FABRICATION D'UN TEL DISPOSITIF**
INTERAKTIVE ANZEIGEVORRICHTUNG UND VERFAHREN ZUR HERSTELLUNG EINER SOLCHEN VORRICHTUNG
INTERACTIVE DISPLAY DEVICE AND METHOD FOR MANUFACTURING SUCH A DEVICE

(30) Priorité: 16.11.2021 FR 2112104
(43) Date de publication de la demande: 17.05.2023
(73) Titulaire: Commissariat à l'Energie Atomique et aux Energies Alternatives, 75015 Paris (FR)
(72) Inventeur: TEMPLIER, François, 38054 Grenoble Cedex 09 (FR); CASSET, Fabrice, 38054 Grenoble Cedex 09 (FR); COLIN, Mikael, 38054 Grenoble Cedex 09 (FR)
(74) Mandataire: Cabinet Beaumont

(56) Documents cités:
- US-A1- 2017 110 504
- US-A1- 2019 065 806
- US-A1- 2019 187 748
- US-A1- 2019 197 284
- US-A1- 2020 395 510

## Description

### Domaine technique

La présente description concerne de façon générale le domaine des dispositifs d'affichage d'images, et vise plus particulièrement un dispositif d'affichage d'images interactif combinant une fonction d'émission lumineuse et une fonction de transduction électromécanique, par exemple une fonction de retour haptique. La présente description vise en outre un procédé de fabrication d'un tel dispositif.

### Technique antérieure

Diverses applications sont susceptibles de tirer profit d'un dispositif d'affichage d'images interactif combinant une fonction d'émission lumineuse et une fonction de transduction électromécanique. Un tel dispositif peut par exemple être utilisé pour réaliser des écrans d'affichage interactifs de grandes dimensions, par exemple des écrans d'ordinateur, de téléviseur, de tablette, etc.

Le document US 2019/197284 décrit des transducteurs ultrasonores incorporés dans un panneau de diodes électroluminescentes organiques et des dispositifs d'affichage contenant de tels transducteurs.

Le document US 2019/187748 décrit un dispositif audio émetteur de lumière, un dispositif d'émission audio et un dispositif d'affichage.

Le document US 2017/110504 décrit un pixel à transducteur ultrasonore micromécanique piézoélectrique intégré et un réseau de tels transducteurs.

### Résumé de l'invention

Un objet d'un mode de réalisation est de pallier tout ou partie des inconvénients des solutions connues pour réaliser un dispositif d'affichage d'images interactif combinant une fonction d'émission lumineuse et une fonction de transduction électromécanique.

Pour cela, l'invention prévoit un dispositif optoélectronique comportant au moins un transducteur électromécanique situé à l'aplomb d'au moins une diode électroluminescente, ledit au moins un transducteur électromécanique et ladite au moins une diode électroluminescente étant connectés à des pistes conductrices d'un même substrat de report.

Selon un mode de réalisation, ledit au moins un transducteur électromécanique et ladite au moins une diode électroluminescente sont situés du côté d'une même face du substrat de report.

Selon un mode de réalisation, ledit au moins un transducteur électromécanique est situé du côté d'une première face du substrat de report et ladite au moins une diode électroluminescente est située du côté d'une deuxième face du substrat de report, opposée à la première face.

Selon un mode de réalisation, le dispositif comporte une pluralité de transducteurs électromécaniques formant une première matrice et une pluralité de diodes électroluminescentes formant une deuxième matrice, la première matrice présentant un pas supérieur à la deuxième matrice.

Selon un mode de réalisation, le dispositif comprend une couche de planarisation s'étendant latéralement entre les diodes électroluminescentes, et un capot de protection transparent recouvrant les diodes électroluminescentes et la couche de planarisation.

Selon un mode de réalisation, le dispositif comprend en outre des piliers traversant la couche de planarisation et reliant mécaniquement les transducteurs au capot de protection transparent.

Selon un mode de réalisation, ledit au moins un transducteur électromécanique présente des dimensions latérales supérieures à ladite au moins une diode électroluminescente.

Selon un mode de réalisation, les pistes conductrices forment un réseau d'interconnexion configuré pour commander ledit au moins un transducteur électromécanique et ladite au moins une diode électroluminescente.

Selon un mode de réalisation, le dispositif comporte en outre, pour chaque transducteur électromécanique, un transistor de sélection connecté audit transducteur électromécanique.

Selon un mode de réalisation, le transistor de sélection comporte une première borne de conduction connectée à une électrode dudit transducteur électromécanique, une deuxième borne de conduction connectée à l'une des pistes conductrices du substrat de report et une borne de commande connectée à une autre piste parmi les pistes conductrices du substrat de report.

Selon un mode de réalisation, ledit au moins un transducteur électromécanique comporte une couche active à base de titano-zirconate de plomb ou de nitrure d'aluminium.

Selon un mode de réalisation ne faisant pas partie de l'invention telle que revendiquée, chaque diode électroluminescente comprend une seule diode élémentaire adaptée à émettre de la lumière dans une plage de longueurs d'ondes.

Selon l'invention, chaque diode électroluminescente comprend une puce élémentaire comportant plusieurs diodes élémentaires adaptées respectivement à émettre de la lumière dans des plages de longueurs d'ondes différentes et un circuit élémentaire de contrôle des diodes élémentaires.

Selon un mode de réalisation, ledit au moins un transducteur électromécanique est un transducteur piézoélectrique.

Selon un mode de réalisation, ledit au moins un transducteur électromécanique est un transducteur PMUT ou CMUT.

L'invention prévoit un procédé de fabrication d'un dispositif optoélectronique comprenant les étapes successives suivantes :
a) former au moins un transducteur électromécanique sur un substrat de report ; et
b) reporter au moins une diode électroluminescente sur le substrat de report, à l'aplomb dudit au moins un transducteur électromécanique,
ledit au moins un transducteur électromécanique et ladite au moins une diode électroluminescente étant connectés à des pistes conductrices du substrat de report.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
les figures 1A, 1B, 1C, 1D et 1E sont des vues en coupe illustrant des étapes successives d'un exemple d'un procédé de fabrication d'un dispositif optoélectronique selon un mode de réalisation ;
la figure 2 est une vue en coupe illustrant une variante du dispositif optoélectronique de la 1E ;
les figures 3A, 3B, 3C, 3D, 3E, 3F, 3G, 3H et 3I sont des vues en coupe illustrant des étapes successives d'un exemple d'un procédé de fabrication d'un dispositif optoélectronique selon un mode de réalisation ;
la figure 4 est une vue de dessus, schématique et partielle, illustrant un exemple de réalisation d'un réseau d'interconnexion d'un dispositif optoélectronique ;
la figure 5 est un schéma électrique équivalent au réseau d'interconnexion de la figure 4 ;
la figure 6 est une vue en coupe illustrant de façon schématique et partielle une variante de réalisation du dispositif optoélectronique de la figure 1E ; et
la figure 7 est une vue en coupe illustrant de façon schématique et partielle une variante de réalisation du dispositif optoélectronique de la figure 6.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés. En particulier, la réalisation des transducteurs électromécaniques, des diodes électroluminescentes (LED) et des circuits intégrés de contrôle des dispositifs décrits n'a pas été détaillée, la réalisation détaillée de ces éléments étant à la portée de la personne du métier à partir des indications de la présente description. Par ailleurs, les diverses applications des dispositifs décrits n'ont pas été détaillées, les modes de réalisation décrits étant compatibles avec toutes ou la plupart des applications susceptibles de tirer profit d'un dispositif combinant une fonction d'émission lumineuse et une fonction de transduction électromécanique.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais "coupled") entre eux, cela signifie que ces deux éléments peuvent être connectés ou être reliés par l'intermédiaire d'un ou plusieurs autres éléments.

On désigne par "transmittance d'une couche" le rapport entre l'intensité du rayonnement sortant de la couche et l'intensité du rayonnement entrant dans la couche. Dans la suite de la description, une couche ou un film est dit opaque à un rayonnement lorsque la transmittance du rayonnement au travers de la couche ou du film est inférieure à 10 %. Dans la suite de la description, une couche ou un film est dit transparent à un rayonnement lorsque la transmittance du rayonnement au travers de la couche ou du film est supérieure à 10 %.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures.

Sauf précision contraire, les expressions "environ", "approximativement", "sensiblement", et "de l'ordre de" signifient à 10 % près, de préférence à 5 % près.

Selon un aspect d'un mode de réalisation, un dispositif optoélectronique combinant une fonction d'émission lumineuse et une fonction de transduction électromécanique, par exemple une fonction de retour haptique, est réalisé par la mise en œuvre d'un procédé comprenant les étapes de former au moins un transducteur électromécanique sur une face d'un substrat de report, puis de reporter au moins une diode électroluminescente (LED) sur le substrat de report, à l'aplomb du transducteur électromécanique.

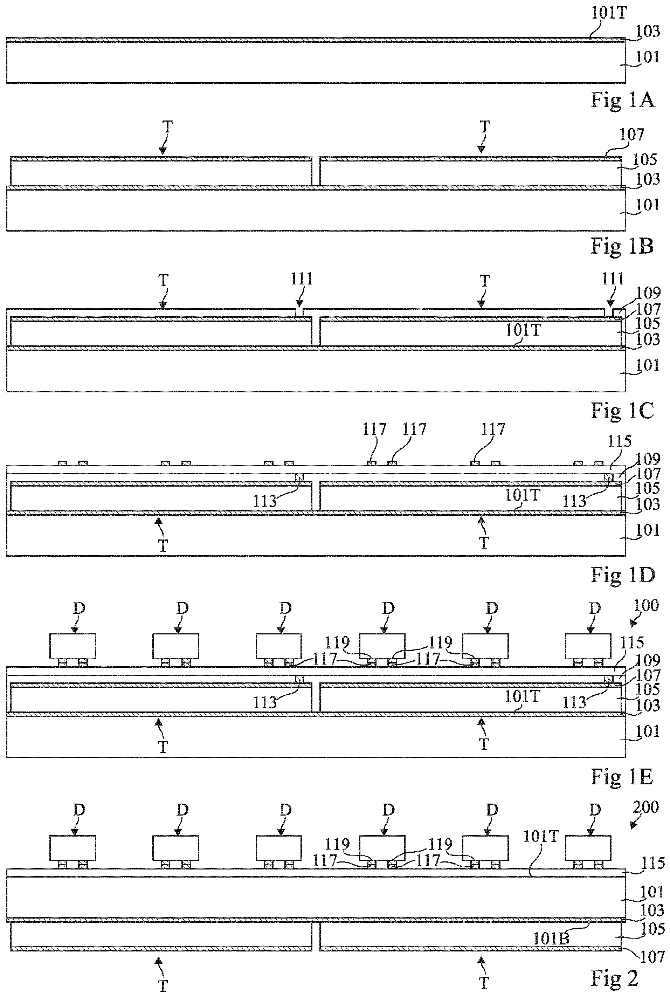

Les figures 1A à 1E sont des vues en coupe illustrant des étapes successives d'un exemple, non limitatif, de mise en œuvre d'un tel procédé. Les igures 1A à 1E illustrent plus précisément des étapes successives de fabrication d'un dispositif optoélectronique 100 comprenant des transducteurs électromécaniques T, par exemple des transducteurs électroacoustiques, par exemple des transducteurs ultrasonores, et des diodes électroluminescentes D situés du côté d'une même face 101T d'un substrat de report 101. Diverses variantes sont à la portée de la personne du métier à partir des indications de la présente description.

Par souci de simplification, les igures 1A à 1E illustrent la réalisation d'un exemple de dispositif optoélectronique comportant deux transducteurs électromécaniques et six diodes électroluminescentes. Cet exemple n'est toutefois pas limitatif, le procédé décrit pouvant bien entendu être adapté pour réaliser des dispositifs optoélectroniques comprenant des nombres de transducteurs électromécaniques et de diodes électroluminescentes différents de ceux représentés, par exemple plusieurs milliers de transducteurs électromécaniques et de diodes électroluminescentes.

La figure 1A est une vue en coupe illustrant une structure obtenue à l'issue d'une étape de formation, sur la face 101T du substrat de report 101 (la face supérieure du substrat de report 101, dans l'orientation de la figure 1A), d'une couche électriquement conductrice 103.

Le substrat de report 101 peut présenter une structure monobloc, ou peut correspondre à une couche recouvrant un support constitué d'un autre matériau. Le substrat de report 101 est par exemple en un matériau transparent, par exemple en verre ou en un polymère transparent. De manière générale, le substrat 101 peut être en tout type de matériau susceptible de recevoir les transducteurs électromécaniques T.

La couche électriquement conductrice 103 revêt la face supérieure 101T du substrat 101 et est destinée à former une ou des électrodes des transducteurs électromécaniques T. Plus précisément, dans l'exemple représenté, la couche 103 s'étend de façon continue sur et en contact avec la face supérieure 101T du substrat 101 et est destinée à former une électrode (l'électrode inférieure, dans l'orientation de la figure 1A) commune aux transducteurs électromécaniques T du dispositif 100. À titre de variante, la couche 103 peut par exemple être gravée, par exemple par photolithographie puis gravure, ou être déposée par un procédé de sérigraphie de sorte à former des parties disjointes de la couche 103 définissant chacune une électrode inférieure de l'un ou de plusieurs des transducteurs électromécaniques T. Des pistes de connexion, non représentées, peuvent en outre être formées dans la couche 103. La couche électriquement conductrice 103 est par exemple en un métal, par exemple l'or, l'argent, le platine, le molybdène, le ruthénium, le titane, etc. ou en un alliage métallique. À titre d'exemple, la couche 103 présente une épaisseur de l'ordre de 300 nm.

La figure 1B est une vue en coupe illustrant une structure obtenue à l'issue d'une étape ultérieure de réalisation, du côté de la face supérieure 101T du substrat 101, des transducteurs électromécaniques T.

Dans l'exemple représenté, chaque transducteur électromécanique T est de type piézoélectrique et comporte une couche active piézoélectrique 105 interposée entre l'électrode inférieure 103 et une autre électrode 107 (l'électrode supérieure, dans l'orientation de la figure 1B). La couche piézoélectrique 105 est par exemple en titano-zirconate de plomb (PZT) ou en nitrure d'aluminium (AlN). L'électrode supérieure 107 est par exemple en un métal, par exemple choisi parmi la liste des métaux indiqués précédemment pour la couche 103, ou en un alliage métallique. L'électrode supérieure 107 est par exemple en le même matériau que l'électrode inférieure 103. À titre d'exemple, l'électrode supérieure 107 présente une épaisseur comprise entre 100 et 500 nm, par exemple de l'ordre de 200 nm. A titre de variante, les électrodes 103 et 107 sont chacune en un matériau conducteur transparent, par exemple un oxyde conducteur transparent (TCO), par exemple de l'oxyde d'indium-étain (ITO). Ceci permet de réaliser un dispositif transparent.

À titre d'exemple, une couche discontinue de colle conductrice, par exemple de type pâte d'argent, est formée par sérigraphie sur la couche 103, le matériau de la couche de colle étant par exemple déposé uniquement à des emplacements où l'on souhaite réaliser les transducteurs électromécaniques T. Un empilement comprenant la couche piézoélectrique 105 et l'électrode supérieure 107 est par exemple ensuite reporté, pour chaque transducteur piézoélectrique T, du côté de la face supérieure 101T du substrat 101. Un appareil de type preneur-placeur ("pick-and-place", en anglais) peut par exemple être utilisé pour positionner chaque empilement comprenant la couche 105 et l'électrode 107 sur la couche conductrice 103. On peut alternativement prévoir que seule la couche piézoélectrique 105 soit d'abord reportée sur la couche 103, les électrodes supérieures 107 étant formées ultérieurement, par exemple par pulvérisation d'une couche métallique à travers un pochoir.

À titre de variante, le matériau de la couche piézoélectrique 105 de chaque transducteur électromécanique T peut être déposé sous forme de couche mince revêtant intégralement la face supérieure de la couche 103, par exemple par un procédé de type sol-gel (par exemple dans le cas du PZT) ou un procédé de pulvérisation (par exemple dans le cas de l'AlN). Des parties disjointes de la couche mince en matériau piézoélectrique peuvent ensuite être formées par photolithographie puis gravure, de sorte à individualiser la couche 105 de chaque transducteur T. Les électrodes supérieures 107 peuvent ensuite être formées, par exemple par une étape de dépôt d'une couche conductrice du côté de la face supérieure 101T du substrat 101, suivie d'étapes de photolithographie et de gravure permettant d'individualiser les électrodes 107 pour chaque transducteur T.

La figure 1C est une vue en coupe illustrant une structure obtenue à l'issue d'une étape ultérieure de dépôt, du côté de la face supérieure 101T du substrat de report 101, d'une couche 109 de passivation des transducteurs T.

Dans l'exemple représenté, la couche 109 revêt les parois latérales des couches piézoélectriques 105 ainsi que les parois latérales et la face supérieure des électrodes supérieures 107 des transducteurs T. Dans cet exemple, la couche 109 comble totalement des espaces s'étendant latéralement entre les transducteurs piézoélectriques T. La couche 109 joue par exemple un rôle de passivation, ou d'encapsulation, des transducteurs T. La couche 109 vise par exemple à protéger les transducteurs T contre des agressions extérieures dues à l'humidité. La couche 109 remplit en outre une fonction de planarisation de la face supérieure de la structure.

La couche 109 est par exemple déposée pleine plaque du côté de la face 101T, puis une étape de planarisation, par exemple un polissage mécano-chimique, est mise en œuvre de manière à obtenir une face supérieure sensiblement plane. La couche 109 est par exemple dans ce cas en dioxyde de silicium (SiO₂). À titre de variante, la couche 109 peut être formée en déposant ou en laminant un polymère, par exemple le benzocyclobutène (BCB), du côté de la face 101T.

En outre, au cours de cette étape, des ouvertures 111 traversantes sont formées dans la couche 109 à l'aplomb des électrodes supérieures 107 des transducteurs piézoélectriques T. Dans l'exemple représenté, une partie de la face supérieure de chaque électrode 107 est exposée au fond de chaque tranchée 111. Les ouvertures 111 de la couche 109 sont par exemple formées par photolithographie puis gravure.

La figure 1D est une vue en coupe illustrant une structure obtenue à l'issue d'une étape ultérieure de formation d'éléments de reprise de contact 113 à l'intérieur des ouvertures 111.

Dans l'exemple représenté, les éléments de reprise de contact 113 comblent intégralement les ouvertures 111 et affleurent la face supérieure de la couche de passivation 109. Les éléments de reprise de contact 113 sont par exemple formés par dépôt pleine plaque d'une couche électriquement conductrice du côté de la face 101T, puis gravure de la couche. À titre d'exemple, les éléments de reprise de contact 113 sont en un métal, par exemple choisi parmi la liste des métaux indiqués précédemment pour la couche 103, ou en un alliage métallique. Les éléments de reprise de contact 113 sont par exemple en le même matériau que les électrodes 107. À titre de variante, les éléments de reprise de contact 113 sont formés par sérigraphie d'un matériau électriquement conducteur de type pâte d'argent. À titre d'exemple, les éléments de reprise de contact présentent une épaisseur de l'ordre de 300 nm.

En outre, au cours de cette étape, un réseau d'interconnexion 115 est réalisé du côté de la face supérieure 101T du substrat de report 101. Le réseau d'interconnexion est plus précisément, dans l'exemple illustré en figure 1D, situé sur et en contact avec la couche de passivation et de planarisation 109. Bien que cela n'ait pas été détaillé en figure 1D, le réseau d'interconnexion 115 comprend par exemple des niveaux de métallisation, par exemple deux niveaux de métallisation, séparés les uns des autres par des couches diélectriques. Chaque niveau de métallisation comporte par exemple plusieurs portions disjointes, isolées électriquement les unes des autres, d'une même couche métallique. En outre, des vias conducteurs non représentés en figure 1D peuvent être réalisés dans le réseau d'interconnexion 115 afin par exemple d'interconnecter plusieurs portions de couches métalliques faisant partie de niveaux de métallisation distincts.

Chaque élément de reprise de contact 113 permet par exemple de connecter l'électrode supérieure 107 de l'un des transducteurs piézoélectriques T à l'un des niveaux de métallisation (non représentés en figure 1D) du réseau d'interconnexion 115.

En outre, au cours de cette étape, des plots métalliques 117 sont formés sur et en contact avec la face supérieure du réseau d'interconnexion 115. Dans cet exemple, les plots 117 sont situés à l'aplomb des transducteurs piézoélectriques T. Les plots 117 sont par exemple connectés à un autre niveau de métallisation du réseau d'interconnexion 115.

La figure 1E est une vue en coupe illustrant une structure obtenue à l'issue d'une étape ultérieure de report, sur le substrat 101, des diodes électroluminescentes D.

Dans l'exemple représenté, les diodes électroluminescentes D sont plus précisément reportées du côté de la face supérieure 101T du substrat de report 101, à l'aplomb des transducteurs piézoélectriques T. Dans cet exemple, les diodes électroluminescentes D et les transducteurs piézoélectriques T sont superposés. Chaque diode électroluminescente D comprend par exemple, comme dans l'exemple illustré en figure 1E, des plots métalliques 119 placés en contact avec les plots métalliques 117 de sorte à connecter les diodes électroluminescentes D au réseau d'interconnexion 115. À titre de variante, les diodes électroluminescentes D peuvent par exemple être connectées aux plots métalliques 117 en utilisant des structures de type métallisation sous bosse ("under bump metallization" - UBM, en anglais), microtube, etc.

Le procédé décrit en relation avec les figures 1A à 1E peut être utilisé pour réaliser des dispositifs d'affichage de grandes dimensions, par exemple des écrans de téléviseur, d'ordinateur, de smartphone, de tablette numérique, etc., combinant une fonction d'affichage d'images et une fonction de transduction électromécanique, par exemple pour réaliser un écran interactif adapté à mettre en œuvre des fonctions de retour haptique, d'émission sonore, de détection de présence d'un doigt (basé sur un procédé comprenant une phase d'émission puis une phase de réception), etc. Un tel dispositif peut comporter une pluralité de puces électroniques élémentaires monolithiques disposées, par exemple selon un agencement matriciel, sur un même substrat de report. Dans le cas du dispositif 100 illustré en figure 1E, les puces électroniques élémentaires peuvent correspondre aux rectangles symbolisant les diodes électroluminescentes D. Les puces élémentaires sont montées solidaires du substrat de report 101 et connectées à des éléments de connexion électrique du substrat de report 101, comprenant par exemple le réseau d'interconnexion 115, pour leur commande. Selon l'invention, chaque puce comporte plusieurs LEDs et un circuit de commande desdites plusieurs LEDs. À titre d'exemple, chaque puce comprend trois LED commandables individuellement, chacune au moyen de son circuit de commande respectif, définissant respectivement trois pixels d'émission adaptés à émettre respectivement de la lumière rouge, de la lumière verte et de la lumière bleue. Chaque puce élémentaire correspond par exemple à un pixel d'affichage du dispositif 100.

Selon une variante ne faisant pas partie de l'invention telle que revendiquée, chaque puce comprend une seule LED individuelle et est dépourvue de circuit de commande intégré. Un circuit de commande externe, par exemple réalisé en technologie TFT (de l'anglais "Thin Film Transistor" - transistor en couche mince) peut alors être formé sur le substrat de report.

La figure 2 est une vue en coupe illustrant une variante du dispositif optoélectronique 100 de la figure 1E. La figure 2 représente plus précisément un dispositif optoélectronique 200 comportant des transducteurs piézoélectriques T et des diodes électroluminescentes D situés respectivement du côté de deux faces opposées d'un même substrat de report.

Le dispositif 200 de la figure 2 comprend des éléments communs avec le dispositif 100 de la figure 1E. Ces éléments communs ne seront pas détaillés à nouveau ci-après. Le dispositif 200 de la figure 2 diffère du dispositif 100 de la figure 1E principalement en ce que, dans le dispositif 200, les transducteurs électromécaniques T sont réalisés du côté d'une deuxième face 101B du substrat de report 101 (la face inférieure du substrat de report 101, dans l'orientation de la figure 2) opposée à la première face 101T. Dans l'exemple représenté, l'électrode commune 103 des transducteurs T revêt la face inférieure 101B du substrat 101. En outre, dans cet exemple, le réseau d'interconnexions 115 est situé sur et en contact avec la face supérieure 101T du substrat 101.

Le dispositif 200 est par exemple réalisé par un procédé analogue au procédé de fabrication du dispositif 100 précédemment décrit en relation avec les figures 1A à 1E. À titre d'exemple, les transducteurs piézoélectriques sont d'abord réalisés du côté de la face 101B, puis le substrat 101 est collé sur un substrat de support temporaire, ou poignée, du côté de la face 101B. On réalise par exemple ensuite le réseau d'interconnexion 115 du côté de la face 101T du substrat de report 101, puis on effectue le report des diodes électroluminescentes D sur les plots de connexion 117 surmontant le réseau d'interconnexion 115. On peut alors par exemple dissocier le substrat de support temporaire du reste de la structure.

On a représenté en figure 2 un exemple dans lequel les transducteurs piézoélectriques T sont dépourvus de couche de passivation. On pourrait toutefois prévoir le dépôt d'une couche de passivation, par exemple une couche analogue à la couche 109 du dispositif 100, du côté de la face inférieure 101B du substrat 101 après fabrication ou report des transducteurs piézoélectriques T.

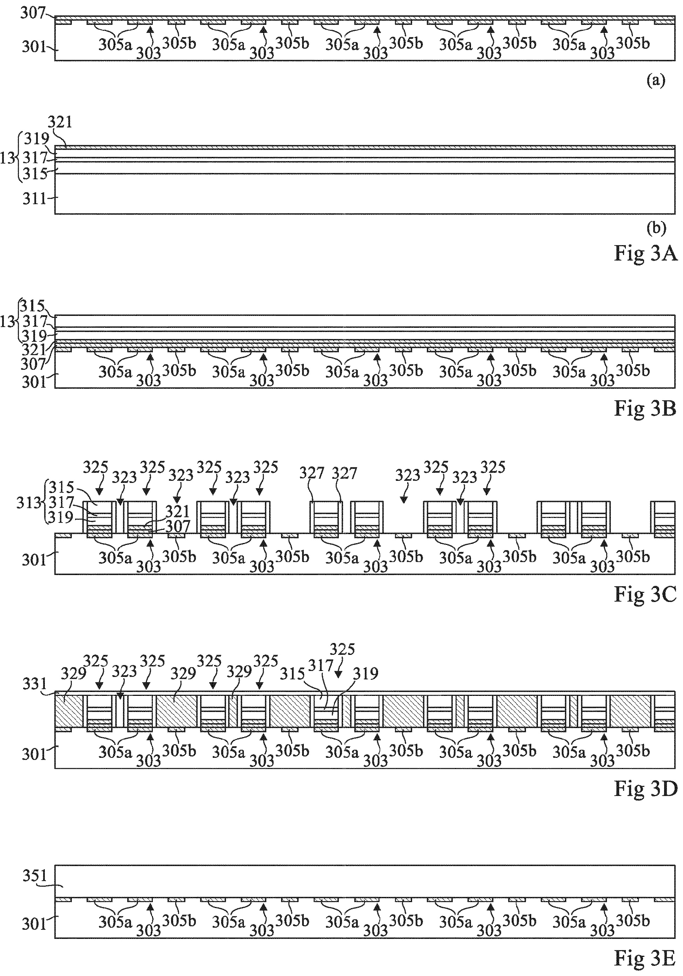

Les figures 3A à 3I sont des vues en coupe illustrant des étapes d'un procédé de fabrication et de report des diodes électroluminescentes D du dispositif 100, 200 dans le cas où chaque diode électroluminescente D correspond à une puce élémentaire de pixel d'affichage du dispositif 100, 200.

La figure 3A comprend une vue (a) représentant de façon schématique une structure de contrôle comprenant un premier substrat 301 dans et sur lequel ont été formés une pluralité de circuits intégrés élémentaires de contrôle 303, par exemple identiques ou similaires, correspondant respectivement aux circuits intégrés de contrôle des futures puces élémentaires de pixel du dispositif 100, 200.

Le substrat 301 peut présenter une structure monobloc, ou peut correspondre à une couche recouvrant un support constitué d'un autre matériau. Le substrat 301 est par exemple en un matériau semiconducteur, par exemple en silicium. À titre d'exemple, le substrat 301 est une plaquette ou un morceau de plaquette en silicium monocristallin, la face supérieure du substrat 301 présentant par exemple une orientation cristalline <111>. Le substrat 301 peut présenter une structure multicouche de type silicium sur isolant, également appelée SOI (de l'anglais "Semiconductor On Insulator" - semiconducteur sur isolant), comportant un substrat semiconducteur de support, par exemple en silicium, une couche isolante, par exemple en oxyde de silicium, disposée sur et en contact avec la face supérieure du substrat de support, et une couche semiconductrice supérieure, par exemple en silicium monocristallin, disposée sur et en contact avec la face supérieure de la couche isolante.

Dans le cas où le substrat 301 est de type SOI, les circuits élémentaires de contrôle 303 sont par exemple formés dans et sur la couche semiconductrice supérieure du substrat 301. Chaque circuit élémentaire de contrôle 303 comprend par exemple une pluralité de transistors MOS (non détaillés sur les figures 3A à 3I). Les circuits élémentaires de contrôle 303 sont par exemple réalisés en technologie CMOS (de l'anglais "Complementary Metal Oxyde Semiconductor" - métal oxyde semiconducteur complémentaire). Chaque circuit élémentaire de contrôle 303 peut comprendre un circuit adapté à contrôler l'émission de lumière par la ou les LED de la future puce élémentaire de pixel du dispositif 100, 200.

Dans cet exemple, chaque circuit élémentaire de contrôle 303 comprend, du côté de sa face supérieure, un ou plusieurs plots de connexion métalliques 305a, 305b. À titre d'exemple, les plots 305a, 305b affleurent du côté de la face supérieure d'une couche isolante supérieure, par exemple en oxyde de silicium, d'un empilement d'interconnexion (non détaillé sur les figures) revêtant la face supérieure de la couche semiconductrice supérieure du substrat 301. Ainsi, dans cet exemple, la surface supérieure de la structure de contrôle de la vue (a) est une surface plane comportant une alternance de régions métalliques (les plots 305a, 305b) et de régions isolantes.

À titre d'exemple, chaque circuit élémentaire de contrôle 303 comprend un plot métallique 305a spécifique pour chaque LED de la future puce élémentaire de pixel du dispositif, destiné à être connecté à une région d'anode de la LED et permettant de commander individuellement l'émission de lumière par ladite LED. Chaque circuit élémentaire de contrôle 303 peut en outre comprendre un plot métallique 305b destiné à être connecté à une région de cathode de chaque LED de la future puce élémentaire de pixel du dispositif. Dans le cas où la puce élémentaire comporte plusieurs LED, le contact de cathode peut être commun à toutes les LED de la puce. Ainsi, le circuit élémentaire de contrôle 303 peut comprendre un unique plot métallique 305b.

À titre d'exemple, chaque puce élémentaire de pixel du dispositif comprend trois LED commandables individuellement adaptées à émettre respectivement de la lumière bleue, de la lumière verte et de la lumière rouge. Dans ce cas, chaque circuit élémentaire de contrôle 303 peut comprendre trois plots métalliques 305a distincts destinés à être connectés respectivement aux régions d'anode des trois LED, et un unique plot métallique 305b destiné à être connecté collectivement aux régions de cathode des trois LED. Sur la vue en coupe de la figure 3A, seuls deux plots métalliques 305a et un plot métallique 305b par circuit électronique ont été représentés.

Dans l'exemple illustré, la surface supérieure de la structure de contrôle de la vue (a) est revêtue d'une couche métallique 307. Dans cet exemple, la couche 307 s'étend de façon continue et avec une épaisseur sensiblement uniforme sur toute la surface supérieure de l'empilement d'interconnexion de la structure de contrôle. Ainsi, la couche 307 connecte les uns aux autres tous les plots métalliques 305a, 305b de la structure de contrôle.

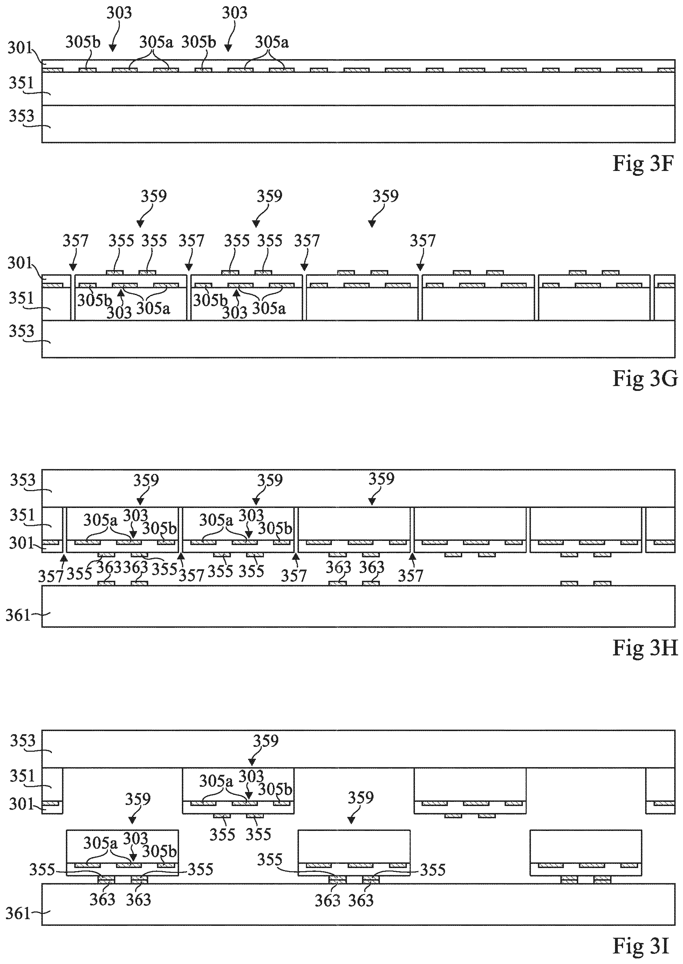

La figure 3Acomprend en outre une vue (b) représentant de façon très schématique une structure comprenant un deuxième substrat 311, sur la face supérieure duquel repose un empilement actif de LED 313. L'empilement actif de LED 313 est par exemple un empilement de LED inorganique, par exemple à base d'un ou plusieurs matériaux semiconducteurs de type III-V, par exemple à base de nitrure de gallium. Le substrat 311 est par exemple en saphir ou en silicium.

L'empilement actif de LED 313 comprend par exemple, dans l'ordre en partant de la face supérieure du substrat 311, une couche semiconductrice 315 dopée de type N formant une couche de cathode, une couche active 317, et une couche semiconductrice 319 dopée de type P formant une couche d'anode. La couche active 317 comporte par exemple une alternance de couches de puits quantiques en un premier matériau semiconducteur et de couches barrières en un deuxième matériau semiconducteur définissant un empilement de puits quantiques multiples. Bien que cela n'ait pas été détaillé en figure 3A, l'empilement actif de LED 313 peut en outre comporter une ou plusieurs autres couches, par exemple choisies parmi des couches d'injection, de transport ou de blocage de charges (électrons ou trous).

L'empilement actif 313 peut être formé par épitaxie sur la face supérieure du substrat 311. À titre de variante, l'empilement actif 313 est formé par épitaxie sur un substrat de croissance, non représenté, puis reporté sur la face supérieure du substrat 311.

À ce stade, l'empilement 313 n'est pas encore structuré en LED individuelles. Autrement dit, les couches de l'empilement 313 s'étendent chacune de façon continue et avec une épaisseur sensiblement uniforme sur toute la surface supérieure du substrat 311.

Dans l'exemple illustré, la surface supérieure de la structure de la vue (b) est revêtue d'une couche métallique 321 sur et en contact avec la face supérieure de l'empilement actif de LED 313. La couche métallique 321 peut être une couche unique ou un empilement de plusieurs couches métalliques. De préférence, la couche métallique 321 comprend, du côté de sa face supérieure, une couche en le même matériau que la couche 307.

La figure 3B illustre la structure obtenue à l'issue d'une étape ultérieure de report et de fixation de l'empilement actif de LED 313 et de la couche métallique 321 sur la structure de la vue (a) de la figure 3A.

Lors de cette étape, la structure de la vue (b) de la figure 3A est rapportée sur la face supérieure de la structure de la vue (a) de la figure 3A, en utilisant le substrat 311 comme poignée. La face inférieure (dans l'orientation de la figure 3B, correspondant à la face supérieure dans l'orientation de la figure 3A) de la couche métallique 321 est fixée sur la face supérieure de la couche métallique 307. La fixation est par exemple obtenue par collage direct ou collage moléculaire de la face inférieure de la couche 321 sur la face supérieure de la couche 307, c'est-à-dire sans apport de matière entre les deux couches.

Le substrat 311 est ensuite retiré, par exemple par meulage et/ou gravure chimique, de façon à libérer l'accès à la face supérieure de l'empilement actif de LED 313, c'est-à-dire, dans cet exemple, la face supérieure de la couche semiconductrice de cathode 315 de l'empilement actif de LED 313.

La figure 3C illustre une étape de formation de tranchées 323 s'étendant verticalement dans l'empilement actif de LED 313 depuis sa face supérieure et délimitant latéralement, dans l'empilement 313, une pluralité d'ilots 325 correspondant aux LED individuelles des futures puces élémentaires du dispositif. Les tranchées 323 sont par exemple formées par gravure plasma. En vue de dessus (non représentée), les tranchées 323 forment une grille séparant latéralement les diodes élémentaires 325 les unes des autres.

La figure 3C illustre en outre une étape ultérieure de prolongement vertical des tranchées 323 à travers les couches métalliques 321 et 307, par exemple en utilisant le même masque de gravure (non représenté) que celui utilisé à l'étape précédente. À l'issue de cette étape, les tranchées 323 débouchent sur la face supérieure de l'empilement d'interconnexion revêtant la face supérieure du substrat 301.

La portion de l'empilement des couches 321 et 307 subsistant sous chaque LED 325 à l'issue de cette étape constitue une électrode d'anode de la LED. Ladite électrode d'anode est en contact, par sa face inférieure, avec la face supérieure d'un plot métallique de connexion 305a du circuit élémentaire de contrôle 303 sous-jacent. Ainsi, chaque LED a son électrode d'anode connectée individuellement à un plot métallique de connexion 305a d'un circuit élémentaire de contrôle 303.

Dans cet exemple, une tranchée 323 est en outre formée en vis-à-vis de chaque plot métallique de connexion 305b de façon à libérer l'accès à la face supérieure des plots 305b.

La figure 3C illustre en outre une étape ultérieure de passivation des flancs des LED 325. Pour cela, une couche 327 en un matériau électriquement isolant, par exemple de l'oxyde de silicium ou du nitrure de silicium, est déposée par une méthode de dépôt conforme sur la face supérieure de la structure. La couche 327 revêt alors la face supérieure et les flancs des LED 325, ainsi que les flancs des portions des couches métalliques 307 et 321 situées sous les LED 325, et, au fond des tranchées 323, la face supérieure de l'empilement d'interconnexion revêtant le substrat 301. Une étape de gravure anisotrope verticale est ensuite mise en œuvre pour retirer les portions horizontales de la couche 327, et conserver uniquement les portions verticales de cette couche, revêtant les flancs des LED 325 et les flancs des portions des couches métalliques 307 et 321 situées sous les LED 325.

La figure 3D illustre une étape ultérieure de remplissage des tranchées 323 par du métal 329. À titre d'exemple, le métal 329 est initialement déposé sur toute la surface supérieure de la structure avec une épaisseur supérieure à la profondeur des tranchées 323, de façon à combler entièrement les tranchées 323. Une étape de planarisation, par exemple par polissage mécano-chimique, est ensuite mise en œuvre pour libérer l'accès à la face supérieure des LED 325. On obtient ainsi une surface supérieure sensiblement plane sur laquelle affleurent les régions semiconductrices de cathode 315 des LED 325, les régions verticales d'isolation 327 des LED, et les régions métalliques 329 remplissant les tranchées 323. En vue de dessus (non représentée), les régions métalliques 329 forment une grille conductrice séparant latéralement les LED 325 les unes des autres. Les régions métalliques 329 sont connectées électriquement aux plots métalliques 305b au fond des tranchées 323, et définissent une métallisation de contact de cathode commune à l'ensemble des LED 325 de la structure.

La figure 3D illustre en outre une étape ultérieure de dépôt d'une couche conductrice 331, transparente aux longueurs d'onde d'émission des LED du dispositif d'affichage, sur la face supérieure de la structure. La couche 331 s'étend par exemple de façon continue et avec une épaisseur sensiblement uniforme sur toute la surface supérieure de la structure. La couche 331 est par exemple en un oxyde conducteur transparent, par exemple en oxyde d'indium-étain (ITO). À titre de variante, la couche 331 peut être une couche métallique suffisamment mince pour être transparente, par exemple une couche d'argent d'épaisseur inférieure à 80 nm.

La couche 331 est en contact, par sa face inférieure, avec la face supérieure des régions semiconductrices de cathode 315 des LED 325, et définit une électrode commune de cathode des LED 325. La couche 331 est en outre en contact, par sa face inférieure, avec la face supérieure de la région métallique 329. Ainsi, la couche 331 connecte électriquement la région semiconductrice de cathode 315 de chaque LED 325 à la métallisation de contact de cathode commune 329 de la structure.

La figure 3E est une vue en coupe illustrant de façon très schématique une structure du type de celle obtenue à l'issue des étapes précédemment décrites en relation avec la figure 3D. Dans l'exemple représenté, la structure comprend plus précisément le substrat 301, dans et sur lequel ont été formés les circuits intégrés élémentaires de contrôle 303, surmonté d'un étage d'émission 351. L'étage d'émission 351 comprend une pluralité de LED (par exemple les LED 325 de la figure 3D, non détaillées sur les figures 3E à 3I) commandables individuellement par les circuits 303. Afin de ne pas surcharger le dessin, seuls les plots 305a et 305b des circuits intégrés de contrôle 303, situés du côté de la face supérieure du substrat 301, ont été détaillés sur les figures 3E à 3I.

La figure 3F illustre une étape de collage de la structure de la figure 3E sur un substrat de support temporaire 353, par exemple en silicium. La structure de la figure 3E est fixée au substrat de support 353 par sa face opposée aux circuits intégrés de contrôle 303, c'est-à-dire par sa face inférieure dans l'orientation de la figure 3F, correspondant à sa face supérieure dans l'orientation de la figure 3E.

La figure 3F illustre en outre une étape optionnelle d'amincissement du substrat semiconducteur 301, par sa face opposée à l'étage 351. Dans le cas où les circuits intégrés de contrôle 303 sont initialement formés dans et sur un substrat de type SOI, l'étape d'amincissement de la figure 3F peut consister à retirer le substrat de support du substrat SOI, de façon à ne conserver que la couche de silicium monocristallin et la couche isolante du substrat SOI.

À titre de variante, dans un cas où les circuits intégrés 303 sont formés dans et sur un substrat massif de silicium, l'étape d'amincissement peut consister à réduire l'épaisseur du substrat 301, par exemple par meulage, à partir de sa face supérieure (dans l'orientation de la figure 3F). Une couche isolante de passivation (non détaillée sur la figure) peut ensuite être déposée sur la face supérieure du substrat 301 aminci.

La figure 3G illustre une étape de formation, du côté de la face supérieure du substrat 301 (dans l'orientation de la figure 3G), de plots métalliques de connexion 355 reliés aux plots de connexion 305a et 305b et/ou à des bornes de connexion de composants électroniques, par exemple des transistors MOS, des circuits intégrés 303, par l'intermédiaire de vias conducteurs non détaillés sur la figure, traversant le substrat semiconducteur 301 des circuits intégrés 303. Les plots 355 étant pour l'essentiel reliés à des bornes de connexion à l'intérieur du circuit, leur nombre est en pratique supérieur au nombre de plots 355.

La figure 3G illustre en outre une étape de formation, à partir de la face supérieure du substrat 301, de tranchées 357 traversant verticalement les circuits intégrés 303 et l'étage 351 d'émission et débouchant sur la face supérieure du substrat de support temporaire 353. Les tranchées 357 délimitent latéralement une pluralité de puces semiconductrices 359 correspondant aux puces élémentaires de pixel du dispositif d'affichage. Les tranchées 357 peuvent être formées par gravure plasma, par sciage, ou par toute autre méthode de découpe adaptée.

Les figures 3H et 3I illustrent une étape de fixation de puces élémentaires 359 sur la face supérieure d'un même substrat de report 361 du dispositif d'affichage. Le substrat de report 361 comprend, du côté de sa face supérieure, une pluralité de plots métalliques de connexion 363, destinés à être fixés et connectés électriquement et mécaniquement à des plots de connexion métalliques correspondants 355 des puces élémentaires 359.

La structure de la figure 3G est retournée (figure 3H) de façon à placer les plots de connexion métalliques 355 de puces élémentaires 359 en vis-à-vis de plots de connexion métalliques 363 correspondants du substrat de report 361. Les plots 355 et 363 en vis-à-vis sont ensuite fixés et connectés électriquement, par exemple par collage direct, par soudure, au moyen de microtubes, ou par toute autre méthode adaptée.

Une fois fixées au substrat de report 361, les puces élémentaires 359 sont détachées du substrat de support temporaire 353, et ce dernier est retiré (figure 3I). À titre d'exemple, le détachage des puces 359 est réalisé par décollement mécanique ou par décollement au moyen d'un faisceau laser. On réalise ainsi un transfert collectif simultané d'une pluralité de puces élémentaires 359 du substrat de support temporaire 353 vers le substrat de report 361.

Le pas (distance centre à centre en vue de face) des puces élémentaires 359 sur le substrat de report 361 est par exemple un multiple du pas des puces élémentaires 359 sur le substrat 353. Ainsi, seule une partie des puces élémentaires 359 (une sur deux, dans l'exemple représenté) est transférée simultanément du substrat de support temporaire 353 sur le substrat de report 361. Les autres puces restent attachées au substrat de support temporaire 353 et peuvent être reportées ultérieurement sur une autre partie du substrat de report 361 ou sur un autre substrat de report.

Dans un cas où le procédé des figures 3A à 3I est mis en œuvre pour fabriquer puis reporter des puces élémentaires du côté de la face 101T du substrat de report 101 du dispositif 100 ou 200, le substrat 361 correspond par exemple au substrat de report 101 surmonté du réseau d'interconnexion 115. Les plots 361 situés en surface du substrat 361 correspondent alors aux plots 117 portés par le réseau d'interconnexion 115, et les plots 355 des puces 359 correspondent aux plots 119 des diodes électroluminescentes D.

On a décrit ci-dessus un exemple de réalisation dans lequel chaque puce élémentaire comprend un empilement d'un circuit intégré de contrôle, par exemple un circuit CMOS, et une ou plusieurs LED inorganiques. A titre de variante, chaque puce élémentaire peut comporter un empilement d'un circuit intégré de contrôle, par exemple un circuit CMOS, et une ou plusieurs LED organiques disposées sur une face du circuit de contrôle.

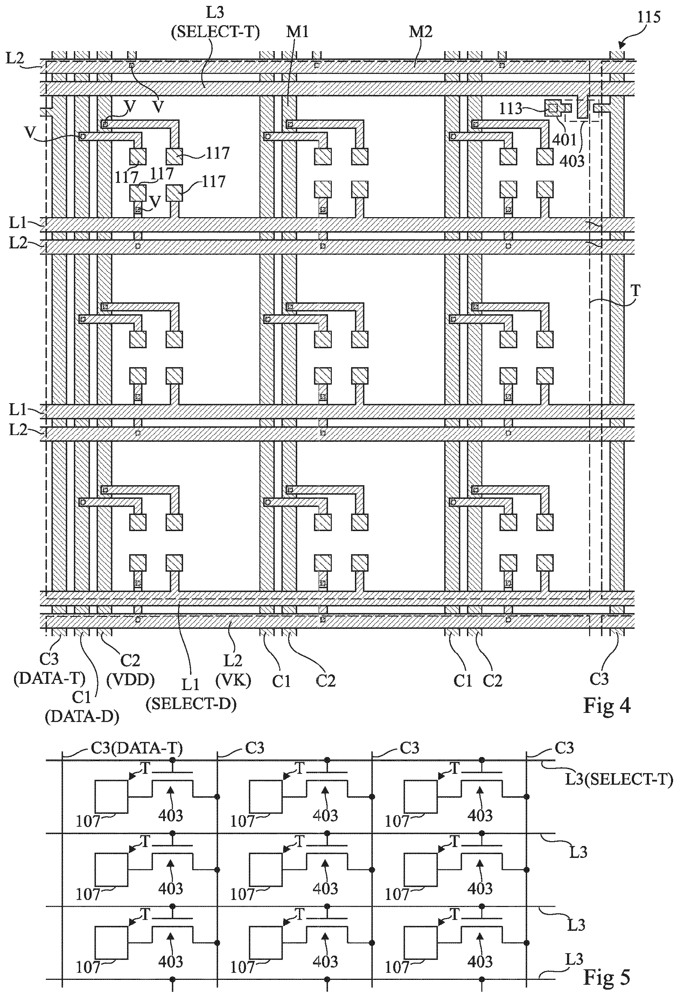

La figure 4 est une vue de dessus, schématique et partielle, illustrant un exemple de réalisation du réseau d'interconnexion 115 du dispositif optoélectronique 100 de la figure 1E. La figure 4 illustre plus précisément un exemple de réalisation du réseau 115 dans le cas où les diodes électroluminescentes D du dispositif 100 correspondent à des puces élémentaires comprenant chacune plusieurs LED commandables individuellement, par exemple trois LED commandables individuellement adaptées à émettre respectivement de la lumière bleue, de la lumière verte et de la lumière rouge.

À des fins de simplification, seule une partie du réseau d'interconnexion 115 située à l'aplomb d'un transducteur piézoélectrique T surmonté de neuf diodes électroluminescentes D du dispositif optoélectronique 100 a été représentée en figure 4.

Le réseau d'interconnexion 115 comporte des éléments de connexion électrique, et en particulier des pistes conductrices et des plages conductrices, formés sur la face supérieure de la couche de planarisation 109. Ces éléments de connexion électrique sont par exemple formés par impression d'une succession de niveaux conducteurs et isolants sur la face supérieure de la couche 109. Les éléments de connexion électrique sont par exemple formés par un procédé de dépôt ou d'impression de type impression jet d'encre, par sérigraphie, par rotogravure, par dépôt sous vide, ou par toute autre méthode adaptée.

Dans l'exemple représenté, le réseau d'interconnexion 115 comprend deux niveaux métalliques conducteurs M1 et M2 superposés et séparés par un niveau isolant (non visible en figure 4), et des vias métalliques V connectant les deux niveaux métalliques M1 et M2 à travers le niveau isolant. Dans cet exemple, le réseau d'interconnexion 115 comprend en outre des plages métalliques de connexion (non visibles en figure 4) formées sur le niveau métallique supérieur M2, destinées à être connectées aux plots de connexion 117.

Dans l'exemple représenté, la fabrication du réseau d'interconnexion 115 comprend les trois étapes successives de dépôt suivantes.

Lors d'une première étape de dépôt, on forme sur la face supérieure de la couche 109 une pluralité de pistes conductrices sensiblement parallèles à la direction des colonnes du dispositif d'affichage (direction verticale dans l'orientation de la figure 4). Plus particulièrement, dans cet exemple, lors de la première étape de dépôt, on forme, pour chaque colonne du dispositif d'affichage, deux pistes conductrices C1 et C2 s'étendant sur sensiblement toute la longueur des colonnes du dispositif d'affichage. Les pistes C1 sont destinées à véhiculer un signal DATA_D de réglage de l'intensité lumineuse émise par les LED des puces élémentaires de la colonne. Les pistes C2 sont destinées à distribuer un potentiel d'alimentation haut VDD aux différentes puces élémentaires de pixel.

Dans cet exemple, lors de la première étape de dépôt, on forme en outre, pour chaque colonne de transducteurs piézoélectriques T, une piste conductrice C3 s'étendant sur sensiblement toute la longueur des colonnes du dispositif d'affichage. La piste C3 est destinée à véhiculer un signal DATA_T permettant par exemple de commander une intensité d'un retour haptique, dans un cas où les transducteurs piézoélectriques T sont adaptés à produire un retour haptique, ou image d'une distance d'un doigt d'un utilisateur par rapport au dispositif 100, dans un cas où les transducteurs piézoélectriques T sont adaptés à détecter la présence d'un doigt.

Dans l'exemple représenté, lors de la première étape de dépôt, on forme en outre, pour chaque transducteur piézoélectrique T, une zone 401 de connexion située sur et en contact avec l'extrémité supérieure de l'élément de reprise de contact 113 du transducteur. Dans cet exemple, la zone 401 est en outre connectée à une première borne de conduction (source ou drain) d'un transistor 403, l'autre borne de conduction du transistor 403 étant connectée à la piste conductrice C3.

Les éléments conducteurs formés lors de cette première étape de dépôt définissent le premier niveau conducteur M1 du substrat de report.

Lors d'une deuxième étape de dépôt, on recouvre le premier conducteur d'un matériau isolant (non visible sur la figure), de façon à permettre le dépôt ultérieur de pistes conductrices s'étendant au-dessus des pistes C1, C2 et C3, sans créer de court-circuit avec les pistes C1, C2 et C3.

Lors d'une troisième étape de dépôt, on forme sur la face supérieure de la couche 109 une pluralité de pistes conductrices sensiblement parallèles à la direction des lignes du dispositif d'affichage. Plus particulièrement, dans cet exemple, lors de la troisième étape de dépôt, on imprime, pour chaque ligne du dispositif d'affichage, deux pistes conductrices L1 et L2 s'étendant sur sensiblement toute la longueur des lignes du dispositif d'affichage. Les pistes L1 sont destinées à véhiculer un signal SELECT_D de sélection de la ligne de pixels correspondante. Les pistes L2 sont destinées à distribuer un potentiel d'alimentation bas VK, par exemple inférieur au potentiel VDD, aux différentes puces élémentaires de pixel.

Dans l'exemple représenté, lors de la troisième étape de dépôt, on forme en outre, pour chaque ligne de transducteurs piézoélectriques, une piste conductrice L3 s'étendant sur sensiblement toute la longueur des colonnes du dispositif d'affichage. La piste L3 est destinée à véhiculer un signal SELECT_T de sélection de la ligne de transducteurs piézoélectriques T correspondante. Dans cet exemple, la piste L3 est connectée à chaque électrode de commande (grille) du transistor 403 de chaque transducteur piézoélectrique T du dispositif 100. Le transistor 403 est par exemple un transistor de sélection adapté à sélectionner le transducteur piézoélectrique T associé en fonction du signal SELECT_T appliqué sur son électrode de commande par la piste L3.

Les éléments conducteurs imprimés lors de cette troisième étape de dépôt définissent le deuxième niveau conducteur M2 du réseau d'interconnexion 115.

Après la troisième étape de dépôt, on vient par exemple former, pour chaque pixel, sur des zones conductrices du niveau métallique M2 (non représentées), quatre plots conducteurs 117 destinés à recevoir respectivement quatre plots de connexion 119 distincts de la puce élémentaire du pixel. Les plots 117 permettent par exemple un adressage séquentiel des trois LED de la puce.

La figure 5 est un schéma électrique équivalent au réseau d'interconnexion de la figure 4. À la différence de la figure 4 illustrant une partie du réseau d'interconnexion 115 comprenant un seul transducteur piézoélectrique T, la figure 5 illustre une partie du réseau d'interconnexion 115 comprenant neuf transducteurs piézoélectriques T. En figure 5, chaque transducteur piézoélectrique T est symbolisé par son électrode supérieure 107. L'électrode inférieure 103 (non visible en figure 4) est par exemple commune à tous les transducteurs T et portée à un potentiel de référence, par exemple la masse.

Le réseau d'interconnexion 115 de la figure 5 fait par exemple partie d'une matrice active de commande des diodes électroluminescentes D et des transducteurs piézoélectriques T du dispositif 100. À titre de variante, le dispositif 100 peut comporter une matrice passive de commande des diodes électroluminescentes D et des transducteurs piézoélectriques T. Dans ce cas, les pistes L3 et les transistors 403 sont par exemple omis et les pistes C3 sont connectées aux électrodes supérieures 107 des transducteurs piézoélectriques T par les éléments de reprise de contact 113. Dans le cas d'une matrice passive, l'électrode inférieure 103 de chaque transducteur piézoélectrique T est par exemple distincte de l'électrode inférieure 103 des autres transducteurs piézoélectriques T du dispositif. Les électrodes inférieures 103 des transducteurs T d'une même colonne sont par exemple connectées à une même piste verticale analogue à la piste C3 mais réalisée par exemple dans la couche métallique où sont formées les électrodes 103.

Alternativement, et selon l'invention, il est prévu de commander les transducteurs piézoélectriques T du dispositif 100 en utilisant des transistors situés dans les circuits de contrôle 303 des puces élémentaires 359 précédemment décrites en relation avec les figures 3G à 3I.

Un avantage des modes de réalisation décrits ci-dessus en relation avec les figures 1A à 1E et avec la figure 2 tient au fait que les transducteurs piézoélectriques T et les diodes électroluminescentes D des dispositifs 100, 200 forment respectivement des première et deuxième matrices pouvant présenter des pas différents. Le pas de la matrice de transducteurs piézoélectriques T est de préférence supérieur au pas de la matrice de diodes électroluminescentes D. Cela permet notamment de réaliser des transducteurs T présentant des dimensions latérales supérieures à celles des diodes électroluminescentes D. Les transducteurs T peuvent ainsi avantageusement produire un retour haptique plus intense que celui qu'on obtiendrait par exemple avec des matrices coplanaires de transducteurs piézoélectriques T et de diodes électroluminescentes D présentant des pas sensiblement égaux.

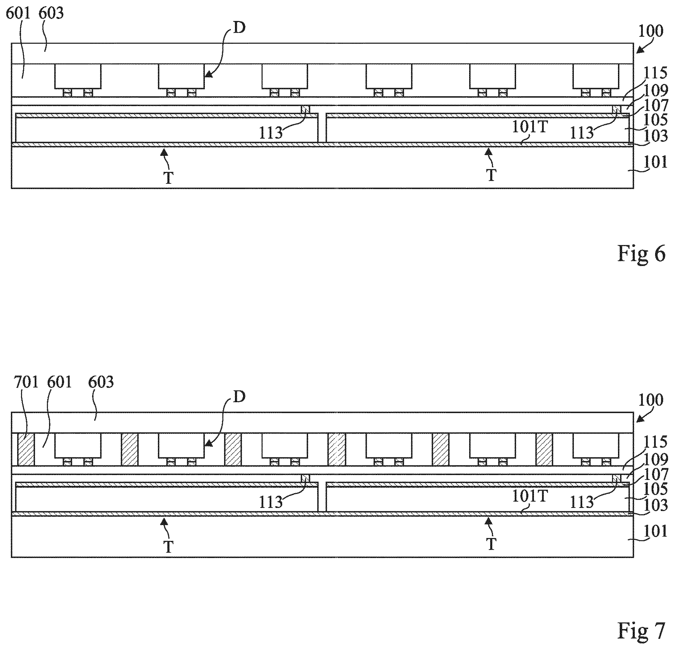

La figure 6 est une vue en coupe illustrant de façon schématique et partielle une variante de réalisation du dispositif optoélectronique de la figure 1E.

Le dispositif de la figure 6 comprend les mêmes éléments que le dispositif de la figure 1E, agencés sensiblement de la même manière.

Dans l'exemple de la figure 6, le dispositif comprend en outre une couche de planarisation 601, par exemple en un matériau polymère, comblant l'espace entre les puces élémentaires D. A titre d'exemple, la couche de planarisation 601 affleure au niveau de la face supérieure des puces élémentaires D. A titre de variante (non représentée), la couche de planarisation recouvre la face supérieure des puces élémentaires D. Dans ce cas, la couche de planarisation 601 est en un matériau transparent aux rayonnements lumineux émis par les LED des puces élémentaires D.

Le dispositif de la figure 6 comprend en outre une couche ou capot de protection transparent 603, par exemple en verre, s'étendant de façon continue sur toute la surface du dispositif, au-dessus de la couche de planarisation 601 et des puces élémentaires D.

La couche de planarisation 601 est en un matériau apte à transmettre les vibrations acoustiques émises et reçues par les transducteurs T.

Optionnellement, la couche de planarisation 601 peut assurer une fonction de collage du capot de protection 603.

Le capot 603 protège le dispositif et peut former une surface d'action haptique du dispositif.

La figure 7 est une vue en coupe illustrant de façon schématique et partielle une variante de réalisation du dispositif optoélectronique de la figure 6.

Le dispositif de la figure 7 comprend les mêmes éléments que le dispositif de la figure 6, agencés sensiblement de la même manière, et comprend en outre des piliers 701 en un matériau plus rigide que le matériau de la couche de planarisation 601, traversant verticalement la couche de planarisation 601 sur toute son épaisseur.

Dans l'exemple représenté, les piliers 701 s'étendent depuis la face inférieure du capot 603, jusqu'à la face supérieure du réseau d'interconnexion 115. A titre de variante, non représentée, les piliers 701 peuvent traverser verticalement le réseau d'interconnexion 115 et déboucher sur la face supérieure des transducteurs T ou de la couche de passivation 109 des transducteurs T.

Le piliers 701 permettent d'assurer une meilleure transmission des vibrations acoustiques émises et reçues par les transducteurs T.

A titre d'exemple, les piliers 701 sont formés dans des ouvertures gravées après le dépôt de la couche de planarisation 601 et avant le dépôt du capot 603.

Les piliers 701 sont par exemple en métal ou en tout autre matériau suffisamment rigide pour transmettre les vibrations acoustiques.

On notera que les variantes des figures 6 et 7 peuvent être combinées avec la variante de la figure 2.

Divers modes de réalisation et variantes ont été décrits. La personne du métier comprendra que certaines caractéristiques de ces divers modes de réalisation et variantes pourraient être combinées, et d'autres variantes apparaîtront à la personne du métier. En particulier, la réalisation, pour le dispositif 200 de la figure 2, d'une matrice active de commande des transducteurs piézoélectriques T et des diodes électroluminescentes D analogue aux matrices actives et passives décrites en relation avec les figures 4 et 5 est à la portée de la personne du métier à partir des indications ci-dessus.

Par ailleurs, bien que l'on ait décrit des modes de réalisation dans lesquels les transducteurs piézoélectriques T sont de forme rectangulaire ou carrée et sont arrangés en matrice, d'autres formes et arrangements sont à la portée de la personne du métier. À titre d'exemple, on pourrait prévoir des transducteurs piézoélectriques T présentant chacun une forme de bande horizontale ou verticale, les transducteurs T du dispositif étant alors par exemple sensiblement parallèles entre eux.

En outre, les modes de réalisation décrits ne se limitent pas aux exemples de matériaux et/ou de dimensions mentionnés dans la présente description.

Enfin, la mise en œuvre pratique des modes de réalisation et variantes décrits est à la portée de la personne du métier à partir des indications fonctionnelles données ci-dessus. En particulier, l'adaptation de la mise en œuvre du procédé décrit en relation avec les figures 1A à 1E pour obtenir une structure du type de celle décrite en relation avec la figure 2 est à la portée de la personne du métier à partir des indications de la présente description.

En outre, la réalisation pratique des transistors de sélection 403 est à la portée de la personne du métier à partir des indications ci-dessus.

Par ailleurs, les modes de réalisation décrits ne se limitent pas aux exemples de transducteurs électromécaniques détaillés ci-dessus. À titre de variante, les transducteurs des exemples décrits ci-dessus peuvent être remplacés par tout autre type de transducteur électromécanique, par exemple des transducteurs électroacoustiques, par exemple des transducteurs ultrasonores, par exemple des transducteurs ultrasonores à membrane. À titre d'exemple, les transducteurs électromécaniques peuvent être des transducteurs capacitifs à membrane, par exemple de type CMUT (de l'anglais "Capacitive Micromachined Ultrasonic Transducer" - transducteur ultrasonore capacitif micro-usiné). À titre de variante, les transducteurs électromécaniques peuvent être des transducteurs piézoélectriques à membrane, par exemple de type PMUT (de l'anglais "Piezoelectric Micromachined Ultrasonic Transducer" - transducteur ultrasonore piézoélectrique micro-usiné).

## Revendications

1. Dispositif optoélectronique (100 ; 200) comportant au moins un transducteur électromécanique (T) situé à l'aplomb d'au moins une diode électroluminescente (D), ledit au moins un transducteur électromécanique et ladite au moins une diode électroluminescente étant connectés à des pistes conductrices (L1, L2, L3, C1, C2, C3) d'un même substrat de report (101), **caractérisé en ce que** :
- chaque diode électroluminescente (D) comprend une puce élémentaire (359) comportant plusieurs diodes élémentaires (325) adaptées respectivement à émettre de la lumière dans des plages de longueurs d'ondes différentes et un circuit élémentaire de contrôle (303) des diodes élémentaires ; et
- chaque transducteur électromécanique (T) est commandé par le ou l'un des circuits élémentaires de contrôle (303) des diodes élémentaires.

2. Dispositif (100) selon la revendication 1, dans lequel ledit au moins un transducteur électromécanique (T) et ladite au moins une diode électroluminescente (D) sont situés du côté d'une même face (101T) du substrat de report (101).

3. Dispositif (200) selon la revendication 1, dans lequel ledit au moins un transducteur électromécanique (T) est situé du côté d'une première face (101B) du substrat de report (101) et ladite au moins une diode électroluminescente (D) est située du côté d'une deuxième face (101T) du substrat de report, opposée à la première face.

4. Dispositif selon l'une quelconque des revendications 1 à 3, comportant une pluralité de transducteurs électromécaniques (T) formant une première matrice et une pluralité de diodes électroluminescentes (D) formant une deuxième matrice, la première matrice présentant un pas supérieur à la deuxième matrice.

5. Dispositif selon la revendication 4, comprenant une couche de planarisation (601) s'étendant latéralement entre les diodes électroluminescentes (D), et un capot de protection transparent (603) recouvrant les diodes électroluminescentes (D) et la couche de planarisation (601).

6. Dispositif selon la revendication 5, comprenant en outre des piliers (701) traversant la couche de planarisation (601) et reliant mécaniquement les transducteurs (T) au capot de protection transparent (603).

7. Dispositif selon l'une quelconque des revendications 1 à 5, dans lequel ledit au moins un transducteur électromécanique (T) présente des dimensions latérales supérieures à ladite au moins une diode électroluminescente (D).

8. Dispositif selon l'une quelconque des revendications 1 à 7, dans lequel les pistes conductrices (L1, L2, L3, C1, C2, C3) forment un réseau d'interconnexion (115) configuré pour commander ledit au moins un transducteur électromécanique (T) et ladite au moins une diode électroluminescente (D).

9. Dispositif selon l'une quelconque des revendications 1 à 8, comportant en outre, pour chaque transducteur électromécanique (T), un transistor de sélection (403) connecté audit transducteur électromécanique.

10. Dispositif selon la revendication 9, dans lequel le transistor de sélection (403) comporte une première borne de conduction connectée à une électrode (107) dudit transducteur électromécanique (T), une deuxième borne de conduction connectée à l'une des pistes conductrices (L1, L2, L3, C1, C2, C3) du substrat de report (101) et une borne de commande connectée à une autre piste parmi les pistes conductrices du substrat de report.

11. Dispositif selon l'une quelconque des revendications 1 à 10, dans lequel ledit au moins un transducteur électromécanique (T) comporte une couche active (105) à base de titano-zirconate de plomb ou de nitrure d'aluminium.

12. Dispositif selon l'une quelconque des revendications 1 à 11, dans lequel ledit au moins un transducteur électromécanique (T) est un transducteur piézoélectrique.

13. Dispositif selon l'une quelconque des revendications 1 à 11, dans lequel ledit au moins un transducteur électromécanique (T) est un transducteur ultrasonore piézoélectrique micro-usiné, PMUT,ou un transducteur ultrasonore capacitif micro-usiné, CMUT.

14. Procédé de fabrication d'un dispositif optoélectronique (100 ; 200) comprenant les étapes successives suivantes :
a) former au moins un transducteur électromécanique (T) sur un substrat de report (101) ; et
b) reporter au moins une diode électroluminescente (D) sur le substrat de report, à l'aplomb dudit au moins un transducteur électromécanique,
ledit au moins un transducteur électromécanique et ladite au moins une diode électroluminescente étant connectés à des pistes conductrices (L1, L2, L3, C1, C2, C3) du substrat de report et **caractérisé en ce que** :
- chaque diode électroluminescente (D) comprend une puce élémentaire (359) comportant plusieurs diodes élémentaires (325) adaptées respectivement à émettre de la lumière dans des plages de longueurs d'ondes différentes et un circuit élémentaire de contrôle (303) des diodes élémentaires ; et
- chaque transducteur électromécanique (T) est commandé par le ou l'un des circuits élémentaires de contrôle (303) des diodes élémentaires.

## Patentansprüche

1. Optoelektronische Einrichtung (100; 200), aufweisend wenigstens einen elektromechanischen Wandler (T), der vertikal in Linie mit wenigstens einer lichtemittierenden Diode (D) angeordnet ist, wobei der wenigstens eine elektromechanische Wandler und die wenigstens eine lichtemittierende Diode mit leitfähigen Leiterbahnen (L1, L2, L3, C1, C2, C3) desselben Transfersubstrats (101) verbunden sind, **dadurch gekennzeichnet, dass**:
- jede lichtemittierende Diode (D) einen elementaren Chip (359) aufweist, der eine Vielzahl von elementaren Dioden (325) aufweist, die jeweils eingerichtet zum Emittieren von Licht in unterschiedlichen Wellenlängenbereichen sind, und eine elementare Steuerschaltung (303) der elementaren Dioden; und
- jeder elektromechanische Wandler (T) durch die oder eine der elementaren Steuerschaltungen (303) der elementaren Dioden gesteuert wird.

2. Einrichtung (100) nach Anspruch 1, wobei der wenigstens eine elektromechanische Wandler (T) und die wenigstens eine lichtemittierende Diode (D) auf der Seite derselben Oberfläche (101T) des Transfersubstrats (101) angeordnet sind.

3. Einrichtung (200) nach Anspruch 1, wobei der wenigstens eine elektromechanische Wandler (T) auf der Seite einer ersten Oberfläche (101B) des Transfersubstrats (101) angeordnet ist und die wenigstens eine lichtemittierende Diode (D) auf der Seite einer zweiten Oberfläche (101T) des Transfersubstrats angeordnet ist, die der ersten Oberfläche gegenüberliegt.

4. Einrichtung nach einem der Ansprüche 1 bis 3, aufweisend eine Vielzahl von elektromechanischen Wandlern (T), die eine erste Matrix ausbilden, und eine Vielzahl von lichtemittierenden Dioden (D), die eine zweite Matrix ausbilden, wobei die erste Matrix eine größere Teilung als die zweite Matrix aufweist.

5. Einrichtung nach Anspruch 4, aufweisend eine Planarisierungsschicht (601), die sich lateral zwischen den lichtemittierenden Dioden (D) erstreckt, und eine transparente Schutzabdeckung (603), die die lichtemittierenden Dioden (D) und die Planarisierungsschicht (601) bedeckt.

6. Einrichtung nach Anspruch 5, ferner aufweisend Säulen (701), die die Planarisierungsschicht (601) durchqueren und die Wandler (T) mechanisch mit der transparenten Schutzabdeckung (603) koppeln.

7. Einrichtung nach einem der Ansprüche 1 bis 5, wobei der wenigstens eine elektromechanische Wandler (T) größere laterale Abmessungen als die wenigstens eine lichtemittierende Diode (D) aufweist.

8. Einrichtung nach einem der Ansprüche 1 bis 7, wobei die leitfähigen Leiterbahnen (L1, L2, L3, C1, C2, C3) ein Verbindungsarray (115) ausbilden, eingerichtet zum Steuern des wenigstens einen elektromechanischen Wandlers (T) und der wenigstens einen lichtemittierenden Diode (D).

9. Einrichtung nach einem der Ansprüche 1 bis 8, ferner aufweisend, für jeden elektromechanischen Wandler (T), einen Auswahltransistor (403), der mit dem genannten elektromechanischen Wandler verbunden ist.

10. Einrichtung nach Anspruch 9, wobei der Auswahltransistor (403) einen ersten Leitungsanschluss aufweist, der mit einer Elektrode (107) des genannten elektromechanischen Wandlers (T) verbunden ist, einen zweiten Leitungsanschluss, der mit einer der leitfähigen Leiterbahnen (L1, L2, L3, C1, C2, C3) des Transfersubstrats (101) verbunden ist, und einen Steueranschluss, der mit einer anderen Leiterbahn unter den leitfähigen Leiterbahnen des Transfersubstrats verbunden ist.

11. Einrichtung nach einem der Ansprüche 1 bis 10, wobei der wenigstens eine elektromechanische Wandler (T) eine aktive Schicht (105) aufweist, die auf einem piezoelektrischen Material auf Bleizirkonat-Titanat-Basis oder auf Aluminiumnitrid-Basis beruht.

12. Einrichtung nach einem der Ansprüche 1 bis 11, wobei der wenigstens eine elektromechanische Wandler (T) ein piezoelektrischer Wandler ist.

13. Einrichtung nach einem der Ansprüche 1 bis 11, wobei der genannte wenigstens eine elektromechanische Wandler (T) ein piezoelektrischer mikromechanischer Ultraschallwandler, PMUT, oder ein kapazitiver mikromechanischer Ultraschallwandler, CMUT, ist.

14. Verfahren zum Herstellen einer optoelektronischen Einrichtung (100; 200), aufweisend die folgenden aufeinanderfolgenden Schritte:
a) Ausbilden wenigstens eines elektromechanischen Wandlers (T) auf einem Transfersubstrat (101); und
b) Übertragen wenigstens einer lichtemittierenden Diode (D) auf das Transfersubstrat, vertikal in Linie mit dem wenigstens einen elektromechanischen Wandler, wobei der wenigstens eine elektromechanische Wandler und die wenigstens eine lichtemittierende Diode mit leitfähigen Leiterbahnen (L1, L2, L3, C1, C2, C3) desselben Transfersubstrats (101) verbunden sind, **dadurch gekennzeichnet, dass**:
- jede lichtemittierende Diode (D) einen elementaren Chip (359) aufweist, der eine Vielzahl von elementaren Dioden (325) aufweist, die jeweils eingerichtet zum Emittieren von Licht in unterschiedlichen Wellenlängenbereichen sind, und eine elementare Steuerschaltung (303) der elementaren Dioden, und
- jeder elektromechanische Wandler (T) durch die oder eine der elementaren Steuerschaltungen (303) der elementaren Dioden gesteuert wird.

## Claims

1. Optoelectronic device (100; 200) comprising at least one electromechanical transducer (T) located vertically in line with at least one light-emitting diode (D), said at least one electromechanical transducer and said at least one light-emitting diode being connected to conductive tracks (L1, L2, L3, C1, C2, C3) of a same transfer substrate (101), **characterized in that**:
- each light-emitting diode (D) comprises an elementary chip (359) comprising a plurality of elementary diodes (325) respectively adapted to emitting light in different wavelength ranges and an elementary control circuit (303) of the elementary diodes; and
- each electromechanical transducer (T) is controlled by the or one of the elementary control circuit(s) (303) of the elementary diodes.

2. Device (100) according to claim 1, wherein said at least one electromechanical transducer (T) and said at least one light-emitting diode (D) are located on the side of a same surface (101T) of the transfer substrate (101).

3. Device (200) according to claim 1, wherein said at least one electromechanical transducer (T) is located on the side of a first surface (101B) of the transfer substrate (101) and said at least one light-emitting diode (D) is located on the side of a second surface (101T) of the transfer substrate, opposite to the first surface.

4. Device according to any one of claims 1 to 3, comprising a plurality of electromechanical transducers (T) forming a first array and a plurality of light-emitting diodes (D) forming a second array, the first array having a greater pitch than the second array.

5. Device according to claim 4, comprising a planarization layer (601) extending laterally between the light-emitting diodes (D), and a transparent protection cover (603) covering the light-emitting diodes (D) and the planarization layer (601).

6. Device according to claim 5, further comprising pillars (701) crossing the planarization layer (601) and mechanically coupling the transducers (T) to the transparent protection cover (603).

7. Device according to any one of claims 1 to 5, wherein said at least one electromechanical transducer (T) has greater lateral dimensions than said at least one light-emitting diode (D).

8. Device according to any one of claims 1 to 7, wherein the conductive tracks (L1, L2, L3, C1, C2, C3) form an interconnection array (115) configured to control said at least one electromechanical transducer (T) and said at least one light-emitting diode (D).

9. Device according to any one of claims 1 to 8, further comprising, for each electromechanical transducer (T), a selection transistor (403) connected to said electromechanical transducer.

10. Device according to claim 9, wherein the selection transistor (403) comprises a first conduction terminal connected to an electrode (107) of said electromechanical transducer (T), a second conduction terminal connected to one of the conductive tracks (L1, L2, L3, C1, C2, C3) of the transfer substrate (101) and a control terminal connected to another track among the conductive tracks of the transfer substrate.

11. Device according to any one of claims 1 to 10, wherein said at least one electromechanical transducer (T) comprises an active layer (105) based on lead zirconate titanate or on aluminum nitride.

12. Device according to any one of claims 1 to 11, wherein said at least one electromechanical transducer (T) is a piezoelectric transducer.

13. Device according to any one of claims 1 to 11, wherein said at least one electromechanical transducer (T) is a piezoelectric micromachined ultrasonic transducer, PMUT, or a capacitive micromachined ultrasonic transducer, CMUT.

14. Method of manufacturing an optoelectronic device (100; 200), comprising the following successive steps:
a) forming at least one electromechanical transducer (T) on a transfer substrate (101); and
b) transferring at least one light-emitting diode (D) onto the transfer substrate, vertically in line with said at least one electromechanical transducer,
said at least one electromechanical transducer and said at least one light-emitting diode being connected to conductive tracks (L1, L2, L3, C1, C2, C3) of the transfer substrate and **characterized in that**:
- each light-emitting diode (D) comprises an elementary chip (359) comprising a plurality of elementary diodes (325) respectively adapted to emitting light in different wavelength ranges and an elementary circuit (303) for controlling the elementary diodes; and
- each electromechanical transducer (T) is controlled by the or one of the elementary control circuit(s) (303) of the elementary diodes.
